# EUROPEAN PATENT APPLICATION

(11) **EP 2 116 900 A1**
(43) Date of publication of application: **11.11.2009**
(21) Application number: 08712104.2
(22) Date of filing: 28.02.2008
(51) Int. Cl.: G03F 7/075, G03F 7/40

(54) **PROCESSED SUBSTRATES HAVING WATER-REPELLENT AREAS IN PATTERNS, PROCESS FOR PRODUCTION THEREOF, AND PROCESS FOR PRODUCTION OF MEMBERS HAVING PATTERMS MADE OF FUNCTIONAL MATERIAL FILMS**

(30) Priority: 01.03.2007 JP 2007051623
(71) Applicant: Asahi Glass Company, Limited, Chiyoda-ku Tokyo 100-8405 (JP)
(72) Inventor: FURUKAWA, Yutaka, Tokyo 100-8405 (JP)
(74) Representative: Müller-Boré & Partner Patentanwälte
(86) International application number: PCT/JP2008/053533
(87) International publication number: WO 2008/105503

(57) **Abstract**

To provide a treated substrate having a high contrast water repellent region on its surface, and a process for producing it.

A treated substrate having a pattern of a water repellent region on a surface of a substrate, **characterized in that** the water repellent region is made of a water repellent cured film obtained by curing a curable composition containing an organopolysiloxane (A1) having hydrogen atoms bonded to silicon atoms and a photocurable group, or an organopolysiloxane (A2) having hydrogen atoms bonded to silicon atoms and having no photocurable group and a compound (B) having a photocurable group, and further optionally containing a photocuring-accelerating compound (C).

## Description

### TECHNICAL FIELD

The present invention relates to a treated substrate having a pattern of a water repellent region on its surface, a process for producing the substrate, and a process for producing a member having a pattern made of a film of a functional material formed thereon using the treated substrate.

### BACKGROUND ART

Many functional thin films are practically used in the fields of semiconductor devices, displays and luminescent elements. Functional thin films are formed by disposing a functional material having a desired property at a desired position, followed by patterning. The functional thin films are used as wiring, electrodes, insulating layers, luminescence layers, optical thin films, etc.

For example, a photoresist pattern obtained by photolithography may be mentioned. However, processes of the photolithography are complex, and utilization efficiency of energy, material, etc. is low. Further, there is a problem such that since the processes of the photolithography are carried out in a clean room, cost of facilities is expensive.

As a method to solve the problems of the photolithography, an ink-jet print method has been proposed. However, in the ink-jet print method, position accuracy is low, and it is difficult to form a fine pattern. Under the circumstance, methods have been proposed to improve the position accuracy by preliminarily forming on a substrate surface a base film with a water repellent/hydrophilic pattern having a water repellent region which repels ink and a hydrophilic region which accepts ink.

For example, Patent Document 1 discloses a method wherein a thin film made of a fluorinated alkylsilane is formed on a hydrophilic surface of a substrate by a chemical vapor deposition method, following by irradiation with ultraviolet light to decompose and remove the thin film made of the fluorinated alkylsilane. In the substrate obtained by the above method, a region not irradiated with light becomes a water repellent region, and a region irradiated with light becomes a hydrophilic region.
Patent Document 1: JP-A-2000-282240

### DISCLOSURE OF THE INVENTION

### OBJECTS TO BE ACCOMPLISHED BY THE INVENTION

In the above conventional method, irradiation with a high energy light having a wavelength less than 200 nm for a long time is required. For this method, special equipments such as a large facility, a vacuum apparatus and a high energy light source are required. Further, since a high energy light having a wavelength less than 200 nm is used in the method, an organic compound in the-thin film of the pattern is also decomposed, and the contrast between the hydrophilic region and the water repellent region in the pattern tends to be low.

Further, on a substrate having a water repellent/hydrophilic pattern formed thereon obtained by a conventional method, a material forming the water repellent region remains. When a hydrophilic functional material is patterned on the substrate and another material is further to be laminated on the entire surface of the substrate, said another material may be repelled by the water repellent region and may not be mixed. Further, when a device is prepared using such a substrate, the material forming the water repellent region may cause inconvenience to operation of the device in some cases

Under these circumstances, it is an object of the present invention to provide a treated substrate having a high contrast pattern of a water repellent region. Another object of the present invention is to provide a process for producing such a treated substrate with a low amount of light in a short time without requiring special equipments or high energy light, or irradiation with light for a long time. Another object of the present invention is to provide a process for producing a member having a pattern of a functional material formed thereon using such a treated substrate. Further, still another object of the present invention is to provide a process for producing a member on which a pattern of a functional material is formed and then from which a material forming a water repellent region is removed.

### MEANS TO ACCOMPLISH THE OBJECTS

The present invention provides the following treated substrate, process for producing it, and process for producing a functional film-formed member using the treated substrate.
<1> A treated substrate having a pattern of a water repellent region on a surface of a substrate, **characterized in that** the water repellent region is made of a water repellent cured film obtained by curing a curable composition containing the following compound (A1), or the following compound (A2) and the following compound (B), and further optionally containing a photocuring-accelerating compound (C):
   compound (A1): an organopolysiloxane having hydrogen atoms bonded to silicon atoms and a photocurable group;
   compound (A2): an organopolysiloxane having hydrogen atoms bonded to silicon atoms and having no photocurable group; and
   compound (B): a compound having a photocurable group.
<2> A process for producing a treated substrate having a pattern of a water repellent region on its surface, **characterized in that** a treated substrate having a pattern of a water repellent region made of a water repellent cured film on its surface is produced by a process comprising a step of forming a coating film containing the above curable composition on a surface of a substrate, a step of irradiating a part of the surface of the coating film with light to cure the curable composition at the portion irradiated with light thereby to form a water repellent cured film, and a step of removing an uncured curable composition present on the surface of the substrate, in this order.
<3> A process for producing a functional film-formed member, **characterized in that** a pattern of a functional film is formed on a surface of a substrate by a process comprising a step of supplying a liquid containing a functional material and a solvent to a surface of the above treated substrate to coat the region other than the water repellent region on the surface of the treated substrate with the liquid, and a step of removing the solvent from the liquid to form a pattern made of a film of the functional material.
<4> A process for producing a functional film-formed member, **characterized in that** a pattern of a functional film is formed on a surface of a substrate by a process comprising a step of supplying a liquid containing a functional material and a solvent to a surface of the above treated substrate to coat the region other than the water repellent region on the surface of the treated substrate with the liquid, a step of removing the solvent from the liquid to form a pattern made of a film of the functional material, and a step of removing the water repellent cured film.

In the treated substrate of the present invention according to the above <1>, it is preferred that the functional group reactive by light is an acryloyl group or a methacryloyl group, and the compound (c) which accelerates the photoreaction is a polymerization initiator which generates radicals by light.

Further, it is preferred that the functional group reactive by light is a 1,2-epoxy group, and the compound (c) which accelerates the photoreaction is a polymerization initiator which generates cations by light.

Further, it is preferred that the functional group reactive by light is a vinyl group, and the compound (c) which accelerates the photoreaction is a platinum catalyst.

In the treated substrate of the present invention according to the above <1>, it is preferred that the contact angle of the substrate surface other than the water repellent region to water is at most 50°, and the contact angle of the water repellent region to water is at least 70°. Further, it is preferred that the film thickness of the water repellent film is from 0.1 to 100 nm.

In the treated substrate of the present invention according to the above <1>, it is preferred that in the compound (A1) or compound (A2), the average number of hydrogen atoms bonded to silicon atoms is preferably from 0.1 to 1.0 atom per one silicon atom.

In the process for producing a treated substrate according to the above <2>, it is preferred that light having a wavelength of at least 200 nm is applied.

In the process for producing a functional film-formed member according to the above <4>, it is preferred that the water repellent cured film is removed by washing with an alkaline solution.

### EFFECTS OF THE INVENTION

The treated substrate of the present invention has a high contrast water repellent region on its surface.

According to the process for producing a treated substrate of the present invention, a treated substrate can be formed with a low amount of light in a short time using a simple apparatus and light source without using a large facility, a vacuum apparatus and a high energy light source.

Using the treated substrate of the present invention, a member having a pattern made of a film of a functional material formed thereon can easily be obtained, which can be used for various applications. Further, after a pattern of a functional material is formed, the water repellent cured film can be removed.

### BRIEF DESCRIPTION OF DRAWINGS

Fig. 1 is a cross section schematically illustrating a process for producing a treated substrate of the present invention.
Fig. 2 is a cross section schematically illustrating a process for producing a member of the present invention.
Fig. 3 shows SEM photographs (magnification: 300 times) of a treated substrate having a water repellent/hydrophilic pattern formed thereon and a treated substrate after immersed in a sodium hydroxide aqueous solution in Examples.

### MEANINGS OF SYMBOLS

0: Substrate
1: Base
2: Hydrophilic thin film
3: Coating film of curable composition
4: Water repellent cured film
5: Photomask
6: Light
7: Non-water repellent region
8: Water repellent region
9: Treated substrate
10: Liquid supplying apparatus
11: Liquid containing functional material
12: Film of functional material
13: Functional film-formed member

### BEST MODE FOR CARRYING OUT THE INVENTION

Hereinafter, a polymerizable functional group selected from an acryloyl group and a methacryloyl group is referred to as a (meth)acryloyl group. Further, a (meth)acrylate means an acrylate or a methacrylate.

### <COMPOUND (A1), COMPOUND (A2)>

The curable composition of a present invention is a curable composition containing the compound (A1), or containing both the compound (A2) and the compound (B).

Each of the compound (A1) and the compound (A2) is an organopolysiloxane. The organopolysiloxane is a compound having a polysiloxane skeleton and organic groups bonded to silicon atoms forming the skeleton. The organic group bonded to the silicon atom is bonded by a carbon-silicon bond. That is, this organic group is an organic group in which the terminal atom bonded to the silicon atom is a carbon atom. To a silicon atom in the organopolysiloxane, at least one organic group is bonded, and in many cases, one or two organic groups are bonded except for a terminal silicon atom, and at most three organic groups are bonded to the terminal silicon atom. In some cases, a small amount of silicon atoms to which no organic group is bonded are present. The polysiloxane skeleton has a linear structure having no branch, a linear structure having a branch, a cyclic structure or a network structure. To the silicon atoms in the skeleton, two monovalent organic groups, monovalent atoms or the like are bonded, and at the branched moiety, a silicon atom to which one monovalent organic group, monovalent atom or the like is bonded or a silicon atom to which no such group nor atom is bonded, is present.

In the organopolysiloxane, except for the terminal silicon atom, silicon atoms have two monovalent groups or atoms, and at least one of them is preferably an organic group. The group or the atom other than the organic group may, for example, be a hydrogen atom, a hydroxyl group, a halogen atom or a hydrolyzable group such as an alkoxy group. It is preferred that to the terminal silicon atom, three organic groups are bonded, or two organic groups and one monovalent group or atom are bonded.

The above monovalent organic group is preferably a hydrocarbon group, a fluoroorganic group or a hydrocarbon group having a substituent (such as a (meth)acryloyl group). The hydrocarbon group is preferably an alkyl group, an alkenyl group, an alkynyl group or an aryl group. In the hydrocarbon group having a substituent also, the hydrocarbon group excluding the substituent moiety (which is meant for a hydrocarbon group assuming that a hydrogen atom is bonded instead of the substituent) is preferably the above group. The hydrocarbon group bonded to the silicon atom is preferably an alkyl group having at most 4 carbon atoms, an alkenyl group or an alkynyl group having at most 4 carbon atoms, or an aryl group having at most 8 carbon atoms, except for the following organic group which increases water repellency or the following photocurable group. Among them, preferred is a methyl group, an ethyl group or a phenyl group, particularly preferred is a methyl group. A plurality of the organic groups in the organopolysiloxane may be different from one another. For example, as organic groups, two types of organic groups i.e. methyl groups and phenyl groups may be present in one molecule.

In order to increase water repellency of the water repellent cured film, an organic group which increases water repellency may be bonded to the compound (A1) or the compound (A2). The organic group which increases water repellency may, for example, be a fluoroorganic group or a long chain hydrocarbon group, and is preferably a fluoroorganic group. The long chain hydrocarbon group may be a C₅₋₂₀ linear alkyl group or alkenyl group, preferably a C₆₋₁₆ linear alkyl group. The fluoroorganic group is preferably a polyfluoroalkyl group which may contain an etheric oxygen atom. Particularly preferred is a polyfluoroalkyl group having a difluoromethylene linkage or a polyfluoroalkyl group having a perfluorooxyalkylene group.

The photocurable group in the compound (A1) is a group included in the above organic group bonded to the silicon atom. The photocurable group is preferably a (meth)acryloyl group, a 1,2-epoxy group or an unsaturated hydrocarbon group. The organic group having a (meth)acryloyl group or a 1,2-epoxy group is preferably an organic group having a structure bonded to the alkyl group directly or via a connecting group. Hereinafter, an organic group having such a photocurable group will sometimes be referred to as a photocurable organic group. The (meth)acryloyl group is preferably bonded to the alkyl group via an oxygen atom. That is, the photocurable organic group is preferably a (meth)acryloyloxyalkyl group. The 1,2-epoxy group is preferably bonded to the alkyl group via a connecting group, and the epoxy-containing group bonded to the alkyl group may, for example, be a glycidyloxy group or a 3,4-epoxycyclohexyl group. The unsaturated hydrocarbon group is preferably an alkenyl group having an unsaturated double bond at the non-bonded terminal (the terminal at a side not bonded to the silicon atom), such as a vinyl group or an allyl group. The organic group having a (meth)acryloyl group is preferably a (meth)acryloyloxyalkyl group in which the alkyl moiety has from 2 to 6 carbon atoms, particularly preferably a (meth)acryloyloxytrimethylene group. The organic group having a 1,2-epoxy group is preferably a glycidyloxyalkyl group in which the alkyl moiety has from 2 to 6 carbon atoms, particularly preferably a 3-glycidyloxypropyl group. The unsaturated hydrocarbon group is preferably a vinyl group.

In the compound (A1) or the compound (A2), presence of hydrogen atoms bonded to silicon atoms is so as to obtain alkali solubility of a water repellent cured film obtained by curing a composition containing such a compound. The water repellent cured film having the hydrogen atoms can be removed by washing with an alkaline aqueous solution. However, in a case where the photocurable organic group is an unsaturated hydrocarbon group, hydrogen atoms bonded to the silicon atoms are required for the curing reaction, and accordingly sufficient number of hydrogen atoms so that the hydrogen atoms remain even after curing are required for the compound (A1) or the compound (A2).

The compound (A1) is an organopolysiloxane having hydrogen atoms bonded to silicon atoms and a photocurable group. This organopolysiloxane has, in addition to the hydrogen atoms and the photocurable organic group, a hydrocarbon group and a fluoroorganic group, and the hydrocarbon group is preferably an alkyl group or a phenyl group, particularly preferably a methyl group. In the compound (A1), the average number of hydrogen atoms bonded to silicon atoms is preferably from 0.1 to 1.0 atom, particularly preferably from 0.5 to 0.9 atom, per one silicon atom. In the compound (A1), the average number of the photocurable organic group is preferably from 0.01 to 0.5 group, particularly preferably from 0.05 to 0.1 group, per one silicon atom. If the number of hydrogen atoms bonded to silicon atoms or the number of the photocurable organic group is too small, the curing property tends to decrease, and if the number is too large, the water repellency tends to decrease.

Further, the weight average molecular weight of the compound (A1) is preferably at least 500, and preferably less than 1,000,000, more preferably less than 10,000. When the weight average molecular weight is at least 500, evaporation from the substrate surface can be prevented, and when the weight average molecular weight is less than 1,000,000, the solubility in a solvent will be improved, whereby the operation efficiency will be improved. The weight average molecular weight is measured by means of gel permeation chromatography using a polystyrene as a standard substance.

The compound (A2) is an organopolysiloxane having hydrogen atoms bonded to silicon atoms and having no photocurable group. This organopolysiloxane has organic groups other than a photocurable organic group and has hydrogen atoms, and such an organic group is preferably a hydrocarbon group or a fluoroorganic group. The hydrocarbon group is preferably an alkyl group or a phenyl group, particularly preferably a methyl group. In the compound (A2), the average number of hydrogen atoms bonded to silicon atoms is preferably from 0.1 to 1.0 atom, particularly preferably from 0.5 to 0.9 atom, per one silicon atom. If the number of hydrogen atoms bonded to silicon atoms is less than 0.1 atom, the releasability may decrease.

Further, the weight average molecular weight of the compound (A2) is preferably at least 500, and preferably less than 1,000,000, more preferably less than 10,000. When the weight average molecular weight is at least 500, evaporation from the substrate surface can be prevented, and when the weight average molecular weight is less than 1,000,000, the solubility in a solvent will be improved, whereby the operation efficiency will be improved. The meaning of the weight average molecular weight is as defined for the above compound (A1).

Each of the compound (A1) and the compound (A2) is preferably an organopolysiloxane having a linear structure, or a hydrolytic condensate of a hydrolyzable silane compound.

The organopolysiloxane having a linear structure is preferably a compound having organosiloxane units represented by the following formula (a1). A compound of the following formula (a1) wherein n is an integer of at least 1 (provided that when W¹ is Q¹, n may be 0) corresponds to the compound (A1) and a compound of the following formula (a1) wherein n is 0 (provided that W¹ is not Q¹) corresponds to the compound (A2). In the following formula (a1), m, n and k represent the numbers of the respective organosiloxane units, and they do not mean that the respective organosiloxane units form blocks. The organopolysiloxane is usually a random copolymer of the respective organosiloxane units. 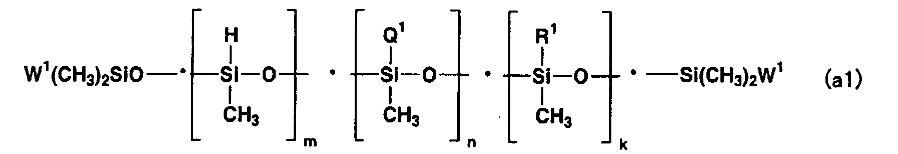 wherein Q¹ is a photocurable organic group, R¹ is an organic group other than a photocurable organic group, W¹ is a hydrogen atom, Q¹ or R¹, and each of m, n and k is an integer of at least 0, provided that when W¹ is not a hydrogen atom, m is an integer of at least 1.

In the above formula (a1), when W¹ is a hydrogen atom, m may be 0, but even when W¹ is a hydrogen atom, m is preferably an integer of at least 1. R¹ is preferably a hydrocarbon group or a fluoroorganic group, more preferably a methyl group or a fluoroorganic group. In a case where a plurality of R¹'s are present (in a case where k is at least 2 and/or W¹ is R¹), the plurality of R¹'s may be different.

Among compounds represented by the formula (a1), a compound having Q¹ (a compound wherein n is at least 1, or a compound wherein n is 0 and at least one W¹ is Q¹) is the compound (A1), and a compound having no Q¹ is the compound (A2). In a case where k is a number of at least 1, when R¹ is a hydrocarbon group, such a compound is likely to be soluble in a hydrocarbon solvent. In a case where R¹ is a fluoroorganic group, a water repellent cured film obtained by curing a composition containing such a compound may have oil repellency in addition to water repellency.

In a case where Q¹ is an organic group having a (meth)acryloyl group, preferred is a group represented by Q¹¹-Y¹-, wherein Q¹¹ is a (meth)acryloyloxy group. Y¹ is -(CH₂)₃-, -(CH₂)₄-, -(CH₂)₅- or -(CH₂)₆-, preferably -(CH₂)₃-. As specific examples of Q¹, CH₂=CHCOO(CH₂)₃- or CH₂=C(CH₃)COO(CH₂)₃- may be mentioned.

In a case where Q¹ is an organic group having a 1,2-epoxy group, preferred is a group represented by Q¹²-Y¹-, wherein Q¹² is a glycidyl group, and Y¹ is the above polymethylene group. Preferred is a 3-glycidyloxypropyl group.

In a case where Q¹ is an unsaturated hydrocarbon group, preferred is a vinyl group or an allyl group, particularly preferred is a vinyl group.

In a case where R¹ is a hydrocarbon group, preferred is an alkyl group having at most 4 carbon atoms, particularly preferred is a methyl group. In a case where R¹ is a fluoroorganic group, preferred is a group represented by R^{f1}-Z¹-, wherein R^{f1} is a fluoroalkyl group having at least 1 carbon atom which may contain an etheric oxygen atom, and Z¹ is a bivalent connecting group containing no fluorine atom.

The R^{f1} group is preferably a C₁₋₁₂ fluoroalkyl group which may contain an etheric oxygen atom, more preferably a C₁₋₁₂ perfluoroalkyl group which may contain an etheric oxygen atom, particularly preferably a C₃₋₁₂ perfluoroalkyl group which may contain an etheric oxygen atom.

The structure of the R^{f1} group may be a linear structure, a branched structure, a cyclic structure or a structure having a partially cyclic structure, and the linear structure is preferred.

As specific examples of the R^{f1} group, the following groups may be mentioned:
F(CF₂)₄-, F(CF₂)₆-, F(CF₂)₈-, H(CF₂)₄-, H(CF₂)₆- and H(CF₂)₈-.
CF₃CF₂OCF₂CF₂OCF₂-, CF₃CF₂OCF₂CF₂OCF₂CF₂-, CF₃CF₂OCF₂CF₂OCF₂CF₂OC F₂CF₂OCF₂- and CF₃CF₂OCF₂CF₂OCF₂CF₂OCF₂CF₂OCF₂CF₂-.
CF₃CF₂CF₂OCF₂-, CF₃CF₂CF₂OCF₂CF₂-, CF₃CF₂CF₂OCF(CF₃)-, CF₃CF₂CF₂OC F(CF₃)CF₂-, CF₃CF₂CF₂OCF(CF₃)CF₂OCF₂CF₂-, CF₃CF₂CF₂OCF(CF₃)CF₂OCF(CF₃)-and CF₃CF₂CF₂OCF(CF₃)CF₂OCF(CF₃)CF₂-.

Z¹ is preferably a group represented by -(CH₂)_{g}-, -SO₂NR³-(CH₂)_{g}- or -(C=O)-NR³-(CH₂)_{g}-, wherein g is a number of from 1 to 5, and R³ is a hydrogen atom, a methyl group or an ethyl group. Z¹ is particularly preferably -(CH₂)₂-. As the direction of the group Z¹, Si is bonded to the right side, and R^{f1} is bonded to the left side.

W¹ is preferably a hydrogen atom or a methyl group.

The organosiloxane unit having the photocurable organic group Q¹ may be present at any position in the molecule, but is preferably present at the terminal of the polysiloxane skeleton (main chain), since high reactivity is obtained when it is present at the terminal of the molecule.

As the compound (A1) or the compound (A2) in the present invention, a commercially available compound having a linear structure represented by the above formula (a1) may be used. As the commercially available compound (A1), the following may be mentioned:

KF-99 manufactured by Shin-Etsu Chemical Co., Ltd. (a compound of the above formula (a1) wherein m is a number of at least 1, n=0, k=0 and W¹=CH₃),

HMS-301 manufactured by Gelest, Inc. (a compound of the above formula (a1) wherein m is a number of at least 1, n=0, k is a number of at least 1, R¹=CH₃ and W¹=CH₃), and

DMS-H21 manufactured by Gelest, Inc. (a compound of the above formula (a1) wherein m=0, n=0, k is at least 1, R¹=CH₃ and W¹=H).

In a case where the compound (A1) or the compound (A2) is a hydrolytic condensate of a hydrolyzable silane compound, it can be prepared by hydrolytic condensation of a hydrolyzable silane compound. Using as the hydrolyzable silane compound, a hydrolyzable silane compound having a hydrogen atom bonded to a silicon atom, a hydrolyzable silane compound having a photocurable organic group, a hydrolyzable silane compound having an organic group other than a photocurable organic group, etc., such hydrolyzable silane compounds are properly combined and subjected to co-hydrolytic condensation to prepare the compound (A1) or the compound (A2). It is preferred to use as the hydrolyzable silane compound mainly a bifunctional hydrolyzable silane compound (i.e. having two hydrolyzable groups) or a trifunctional hydrolyzable silane compound (i.e. having 3 hydrolyzable groups). In addition, as the case requires, a monofunctional hydrolyzable silane compound or a tetrafunctional hydrolyzable silane compound may be used in combination. The monofunctional hydrolyzable silane compound is a compound to be a terminal organosiloxane unit and may function as a molecular weight modifier.

The hydrolyzable group bonded to a silicon atom is a group to be reacted with water and converted to a hydroxyl group, and it may, for example, be a halogen atom such as a chlorine atom, a group having a hydrogen atom of a hydroxyl group removed from a compound having a hydroxyl group (such as an alkoxy group), an acyl group, an isocyanate group, or a group having a hydrogen atom of an amino group removed from an amine. The hydrolyzable group is preferably an alkoxy group having at most 4 carbon atoms, particularly preferably a methoxy group or an ethoxy group. The hydrolyzable group is reacted with water and converted to a hydroxyl group, and then such hydroxyl groups are subjected to dehydrating condensation to form a siloxane bond.

The compound (A1) or the compound (A2) may be prepared from a trifunctional hydrolyzable silane compound and a monofunctional hydrolyzable silane compound. If a trifunctional hydrolyzable silane compound is used, a crosslinked organopolysiloxane may form, thus lowering the solubility in a solvent, but by use of a monofunctional hydrolyzable silane compound in combination, the molecular weight of an organopolysiloxane to be formed can be suppressed, and a product soluble in a solvent can be obtained. This product is considered to be an organopolysiloxane having a crosslinked structure of a branched structure, and is considered to have unreacted silanol groups (hydroxyl groups bonded to silicon atoms). Even such a compound (A1) or a compound (A2), when it has hydrogen atoms bonded to silicon atoms, is soluble in an alkaline aqueous solution even after curing. The compound (A1) or the compound (A2) can be prepared also from a trifunctional hydrolyzable silane compound, a bifunctional hydrolyzable silane compound and a monofunctional hydrolyzable silane compound.

The hydrolyzable silane compound having a hydrogen atom bonded to a silicon atom is preferably a compound represented by the following formula (a2-1) (hereinafter referred to as a compound (a2-1), the same applies hereinafter). The hydrolyzable silane compound having a photocurable organic group is preferably a compound represented by the following formula (a2-2). The hydrolyzable silane compound having an organic group other than a photocurable organic group is preferably a compound represented by the following formula (a2-3). The monofunctional hydrolyzable silane compound is preferably a compound represented by the following formula (a2-4) or (a2-5). The following compound (a2-5) becomes two monovalent organosiloxane units after hydrolyzed.

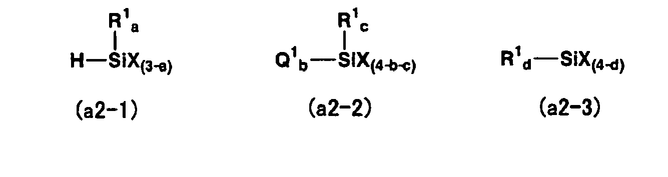

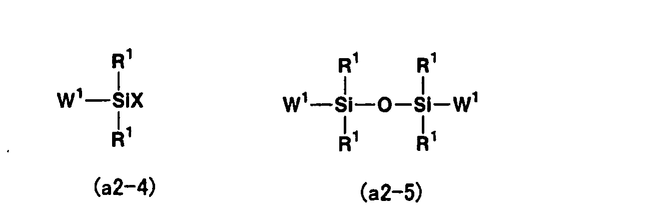

In the above formulae, X is a hydrolyzable group, Q¹ is a photocurable organic group, R¹ is an organic group other than a photocurable organic group, W¹ is a hydrogen atom, Q¹ or R¹, "a" is 0 or 1, b is 1 or 2, c is 0 or 1 (provided that b+c is 1 or 2), and d is 0, 1 or 2.

In the above compounds (a2-1) to (a2-5), Q¹, R¹ and W¹ and their specific examples are as defined above, and their preferred examples are also as defined above. "a" is preferably 0, it is preferred that b is 1 and c is 0, and d is preferably 1 or 2. In a case where d is 2, it is preferred that one R¹ is a fluoroorganic group, and the other R¹ is an alkyl group.

It is considered that an organopolysiloxane represented by the following formula (a2) is formed by hydrolytic condensation of the above hydrolyzable silane compounds. However, the following formula (a2) is a chemical formula represented assuming that all the hydrolyzable groups are subjected to hydrolytic condensation, and in practice, it is considered to be a partial hydrolytic condensate in which hydrolyzable groups or silanol groups remain. 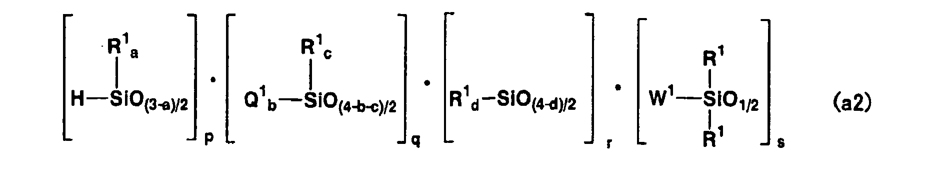 wherein p is an integer of at least 1, q is an integer of at least 0, r is an integer of at least 0, and s is an integer of at least 0. The compound (A1) is a compound having Q¹, and the compound (A2) is a compound having no Q¹.

As preferred specific examples of the compound (a2-1), the following examples may be mentioned:
HSi(OCH₃)₃ and
HSi(OCH₂CH₃)₃.

As preferred specific examples of the compound (a2-2), the following examples may be mentioned:
CH₂=C(CH₃)COO(CH₂)₃Si(OCH₃)₃,
CH₂=C(CH₃)COO(CH₂)₃Si(OCH₂CH₃)₃,
CH₂=CHCOO(CH₂)₃Si(OCH₃)₃,
CH₂=CHCOO(CH₂)₃Si(OCH₂CH₃)₃,
[CH₂=C(CH₃)COO(CH₂)₃]CH₃Si(OCH₃)₂ and
[CH₂=C(CH₃)COO(CH₂)₃]CH₃Si(OCH₂CH₃)₂.

As preferred specific examples of the compound (a2-3), the following examples may be mentioned:
F(CF₂)₄CH₂CH₂Si(OCH₃)₃,
F(CF₂)₆CH₂CH₂Si(OCH₃)₃,
F(CF₂)₈CH₂CH₂Si(OCH₃)₃,
H(CF₂)₄CH₂CH₂Si(OCH₃)₃,
H(CF₂)₆CH₂CH₂Si(OCH₃)₃,
H(CF₂)₈CH₂CH₂Si(OCH₃)₃,
CF₃CF₂CF₂OCF(CF₃)CF₂OCF₂CF₂CH₂CH₂Si(OCH₃)₃.
Si(OCH₃)₄, Si(OCH₂CH₃)₄,
CH₃Si(OCH₃)₃, CH₃Si(OCH₂CH₃)₃,
CH₃CH₂Si(OCH₃)₃, CH₃CH₂Si(OCH₂CH₃)₃,
(CH₃)₂Si(OCH₃)₂ and (CH₃)₂Si(OCH₂CH₃)₂.

As preferred specific examples of the compound (a2-4), the following examples may be mentioned:
H(CH₃)₂Si(OCH₃),
(CH₃)₃Si(OCH₃),
CH₂=C(CH₃)COO(CH₂)₃(CH₃)₂Si(OCH₃) and
F(CF₂)₆CH₂CH₂(CH₃)₂Si(OCH₃).

As preferred specific examples of the compound (a2-5), the following examples may be mentioned:
H(CH₃)₂SiOSi(CH₃)₃H and
(CH₃)₃SiOSi(CH₃)₃.

By hydrolysis and condensation using the compound (a2-1) as an essential component, p in the formula (a2) is a number of at least 1. The same applies to the compounds (a2-2), (a2-3), (a2-4) and (a2-5).

By hydrolysis and condensation using the compound (a2-4) or (a2-5) as a component, the molecular weight of the compound (a2) can be adjusted.

At least two types of compounds corresponding to the compound (a2-1) may be used. The same applies to the compounds (a2-2), (a2-3), (a2-4) and (a2-5).

For the hydrolysis and condensation, it is preferred to use an inorganic acid such as hydrochloric acid, sulfuric acid or nitric acid as a catalyst. As a solvent to be used for the reaction, it is preferred to use a water soluble solvent in which the catalyst is dissolved and a solvent in which a product is dissolved in combination, and the water soluble solvent and the solvent in which a product is dissolved are preferably miscible with each other. Isopropyl alcohol and hexane, or isopropyl alcohol and dichloropentafluoropropane (AK-225 manufactured by Asahi Glass Company, Limited, a mixture of CF₃CF₂CHCl₂ and CClF₂CF₂CHClF) may, for example, be mentioned. The reaction is preferably carried out at a temperature of from room temperature to the boiling point of the solvent.

Each of the compound (A1) and the compound (A2) in the present invention may be a single compound, but is usually a mixture comprising a plurality of compounds differing in the degree of polymerization, etc. In such a mixture, a compound of the above formula wherein at least one of m, n, k, p, q, r and s is out of the above range may coexist. However, it is preferred that the values of m, n, k, p, q, r and s as averages of the entire mixture are respectively preferably within the above ranges. These values bring the weight average molecular weight of the above organopolysiloxane to be within a preferred range.

### <CURABLE COMPOSITION>

The curable composition in the present invention is a composition essentially containing the compound (A1) or a composition essentially containing the above compound (A2) and a compound (B), as a curable component. The compound (B) may be the compound (A1) (that is, the curable composition may be a composition containing the above compound (A1) and the above compound (A2)). However, in the following description, the compound (B) is a compound other than the compound (A1) unless otherwise specified. Further, the curable composition in the present invention may be a composition containing the compound (B) and the above compound (A1). Such a curable composition can be cured by photocuring and converted to a cured product.

The compound (B) is a compound having a photocurable group.

The compound (B) may be an organopolysiloxane. That is, it may be an organopolysiloxane containing no hydrogen atoms bonded to silicon atoms and containing a photocurable organic group. Such an organopolysiloxane may, for example, be an organopolysiloxane represented by the above formula (a1) wherein m is 0 (provided that W¹ is not a hydrogen atom), or an organopolysiloxane obtained by co-hydrolytic condensation of the above compound (a2-2) or the above compounds (a2-2) and (a2-3), with the above compound (a2-4) or (a2-5) (provided that W¹ is not a hydrogen atom).

The compound (B) may be a compound other than an organopolysiloxane. For example, a compound other than an organopolysiloxane, such as a (meth)acrylate, a polyepoxide or a polyvinyl compound may be used. The compound (B) other than the compound (A1) is preferably a (meth)acrylate having no silicon atom, a polyglycidyl compound, or a compound having an alkenyl group having an unsaturated group at a non-bonded terminal (hereinafter referred to as an alkenyl compound).

The above (meth)acrylate is preferably a (meth)acrylate having at least 2, preferably at least 3 (meth)acryloyloxy group. The number of (meth)acryloyloxy groups in one molecule is not particularly limited but is preferably at most 8. As specific examples of the (meth)acrylate, the following compounds may be mentioned.

Pentaerythritol tri(meth)acrylate, pentaerythritol tetra(meth)acrylate, dipentaerythritol penta(meth)acrylate, dipentaerythritol hexa(meth)acrylate, trimethylolpropane tri(meth)acrylate and ditrimethylolpropane tetra(meth)acrylate.

The polyglycidyl compound is preferably an aliphatic or alicyclic compound having at least 2 glycidyl groups. The number of glycidyl groups in one molecule is preferably from 2 to 8, particularly preferably from 3 to 6. For example, an aliphatic polyglycidyl ether or polyglycidyl ester is preferred, and a polyglycidyl ether is particularly preferred. Specifically, triglycidyl ether of trimethylolpropane, triglycidyl ether of glycerol, or triglycidyl ether or tetraglycidyl ether of pentaerythritol may, for example, be mentioned.

The alkenyl compound is preferably an α-olefin having at least 6 carbon atoms, a compound having the above fluoroorganic group and an alkenyl group, or an organopolysiloxane having an alkenyl group bonded to a silicon atom (and having no hydrogen atoms bonded to silicon atoms). The alkenyl group may be bonded to a silicon atom at the molecular terminal or may be bonded to a silicon atom at a position not at the terminal. The alkenyl group bonded to a silicon atom is preferably a vinyl group or an allyl group, particularly preferably a vinyl group. The α-olefin is preferably a C₆₋₂₀ α-olefin. The compound having the above fluoroorganic group and an alkenyl group is preferably a compound represented by the following formula (a3-1). The organopolysiloxane having an alkenyl group bonded to a silicon atom at a position not at the terminal is preferably a compound represented by the following formula (a3-2). The organopolysiloxane having an alkenyl group bonded to a silicon atom at the molecular terminal is preferably a compound represented by the following formula (a3-3).

R^{f1}-Z¹-H=CH₂ (a3-1)

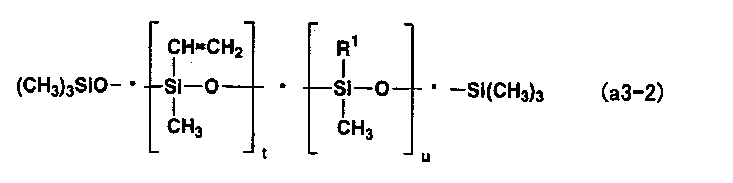

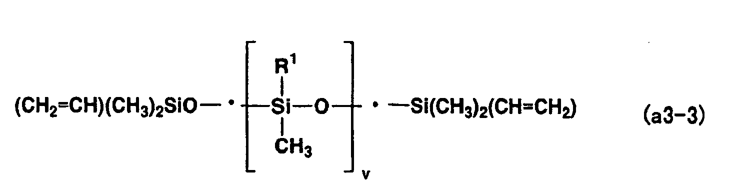

In the above formulae (a3-1) to (a3-3), R^{f1}, Z¹ and R¹ are as defined above, and each of t, u and v is an integer of at least 1. In the above formula (a3-1), R^{f1} is preferably a C₃₋₁₂ perfluoroalkyl group which may contain an etheric oxygen atom, and Z¹ is preferably -(CH₂)_{g}-. In the above formulae (a3-2) and (a3-3), R¹ is preferably a methyl group.

It is preferred to use the compound (B) in an amount of from 0.1 to 100 parts by mass, particularly preferably from 5 to 50 parts by mass per 100 parts by mass of the compound (A2). If the amount of the compound (B) is less than 0.1 part by mass, the photocuring property may decrease. If the amount of the compound (B) exceeds 100 parts by mass, the water repellency may decrease. In a case where the compound (B) is the compound (A1), the upper limit of the amount of use based on the compound (A2) is not particularly limited.

The curable composition in the present invention preferably contains a photocuring-accelerating compound (C). The photocuring-accelerating compound (C) is properly selected depending on the type of the photocurable group in the compound (A1) or the compound (B). In a case where the photocurable group is a (meth)acryloyl group, preferred is a radical generator (photoradical polymerization initiator) which generates radicals by light. The photoradical polymerization initiator absorbs light and generates radicals to initiate the photopolymerization reaction of (meth)acryloyl groups. The photoradical polymerization initiator may be used alone or as a mixture of two or more of them. The amount of the photoradical polymerization initiator is preferably from 0.1 to 50 mass%, more preferably from 1 to 10 mass% based on the total amount of the compound (A1), the compound (A2) and the compound (B).

As specific examples of the photoradical polymerization initiator, the following compounds may be mentioned. 2-Hydroxy-2-methyl-1-phenylpropan-1-one (Dalocure 1173, manufactured by Merck Ltd.), 1-hydroxycyclohexyl phenyl ketone (IRGACURE 184, manufactured by CIBA-GEIGY Limited), 1-(4-isopropylphenyl)-2-hydroxy-2-methylpropan-1-one (Dalocure 1116, manufactured by Merck Ltd.), benzyl dimethyl ketal (IRGACURE 651, manufactured by CIBA-GEIGY Limited), 2-methyl-1-[4-(methylthio)phenyl]-2-morphorlinopropan-1-one (IRGACURE 907, manufactured by CIBA-GEIGY Limited), 2-benzyl-2-dimethylamino-1-(4-morpholinophenyl)-butanone-1 (IRGACURE 369, manufactured by CIBA-GEIGY Limited) and 2,4-diethylthioxanthone (KAYACURE DETX, manufactured by Nippon Kayaku Co., Ltd.).

In a case where the photocurable group is a 1,2-epoxy group, the photocuring-accelerating compound (C) is preferably a cation generator (cationic photopolymerization initiator) which generates cations by light. The cationic photopolymerization initiator absorbs light and generates cations to initiate the photopolymerization reaction of 1,2-epoxy groups. It is preferred to use the cationic photopolymerization initiator and a sensitizer in combination for the purpose of improving the photocuring property. Each of them may be used alone or in combination of two or more of them. The total amount of the cationic photopolymerization initiator and the sensitizer is preferably from 0.1 to 50 mass%, particularly preferably from 1 to 10 mass% based on the total amount of the compound (A1), the compound (A2) and the compound (B).

A representative cationic photopolymerization initiator is an onium salt type cationic photopolymerization imitator, and diphenyl iodonium hexafluorophosphate or triphenylsulfonium hexafluorophosphate may, for example, be mentioned. Specifically, for example, [CH₃-ph-I⁺-ph-CH-(CH₃)₂][PF₆⁻] (wherein ph is a 1,4-phenylene group) is preferred, and a mixture of [CH₃-ph-I⁺-ph-CH-(CH₃)₂][PF₆⁻] (wherein ph is a 1,4-phenylene group) and propylene carbonate in a ratio of 3:1 (IRGACURE 250, manufactured by CIBA-GEIGY Limited) may, for example, be mentioned. The sensitizer may, for example, be a thioxanthone sensitizer. Specifically, for example, 2,4-diethylthioxanthone (KAYACURE DETX, manufactured by Nippon Kayaku Co., Ltd.) is preferred.

In a case where the photocurable group is an alkenyl group, the photocuring-accelerating compound (C) is preferably a platinum catalyst. The platinum catalyst is a catalyst which accelerates reaction of the alkenyl group with the hydrogen atom bonded to the silicon atom (hydrosilylation reaction). The platinum catalyst is preferably a metal complex containing platinum, more preferably a metal complex containing platinum(II). The amount of the platinum catalyst is preferably from 10⁻¹ to 10⁻⁶ by the molar ratio based on hydrogen atoms bonded to silicon atoms, and the platinum catalyst is used preferably in such an amount that the concentration in a solution containing the curable composition and the solvent is from 0.1 ppm to 10,000 ppm. As specific examples of the platinum catalyst, bis(acetylacetonate)platinum(II), dichlorobis-(cyclohexene)-platinum(II) dimmer, dichloro(1,5-cyclooctadiene)platinum(II) or dichlorobis(benzonitrile)platinum(II) may be mentioned.

To form a film of a curable composition to form a water repellent cured film, it is preferred to use a solution of the curable composition to form a coating film (wet film) of the solution, and then to remove the solvent e.g. by evaporation to form a coating film containing the curable composition. The solvent is preferably an alcohol such as methanol, ethanol or isopropanol; an ester such as ethyl acetate or butyl acetate; a hydrocarbon such as hexane; or a fluorine type solvent such as dichloropentafluoropropane (AK-225 manufactured by Asahi Glass Company, Limited, the mixture of CF₃CF₂CHCl₂ and CClF₂CF₂CHClF) or CF₃CH₂OCF₂CHF₂ (AE-3000 manufactured by Asahi Glass Company, Limited). The solid content concentration in the solution is preferably from 0.01 to 50 mass%, more preferably from 0.1 to 10 mass%.

### WATER REPELLENT REGION ON SUBSTRATE SURFACE

The surface of a cured product obtained by curing the above curable composition has water repellency, and accordingly by forming a cured product in the form of a thin film, a cured film having a water repellent surface (that is, water repellent cured film) can be obtained. By forming a pattern by the water repellent cured film, a pattern of a water repellent region (a region on which this water repellent cured film is present) is formed on a substrate. Since the curable composition has photocuring property, a pattern of the water repellent cured film can be formed by a lithography method. Further, a pattern of the water repellent cured film can be formed by forming a thin film pattern of the curable composition by a printing method and curing the curable composition. Further, a pattern of the water repellent cured film can be formed by forming a water repellent cured film and then partially removing the film e.g. by etching. As mentioned above, the means to form the pattern of the water repellent cured film is not limited, but it is preferred to form the pattern of the water repellent cured film by a lithography method as described hereinafter.

On the substrate surface, the water repellent region comprising the surface of the cured product has water repellency, the surface other than the water repellent region (hereinafter referred to as a non-water repellent region) has lower water repellency, and the difference in the water repellency is preferably large. In the present invention, the water repellency means a nature represented by the contact angle to water. The non-water repellent region may have water repellency, may be hydrophobic, or may be hydrophilic so long as it has water repellency relatively lower than that of the water repellent region. The contact angle to water in the water repellent region is preferably at least 70°, particularly preferably at least 85°. The contact angle to water in the water repellent region is most preferably at least 100°. The higher the water repellency, the better, but the upper limit is usually about 150°.

The contact angle to water of the non-water repellent region is preferably lower by at least 20° than that of the water repellent region, and the contact angle to water is particularly preferably at most 50°. The difference in the contact angle to water between the water repellent region and the non-water repellent region is preferably at least 40°, more preferably at least 70°. The larger the difference, the higher the contract of the pattern to be obtained. The contact angle to water of the non-water repellent region itself is preferably at most 40°, particularly preferably at most 20°. In the present invention, water repellency means a nature of a surface having a contact angle to water exceeding 60°, hydrophobicity means a nature of a surface having a contact angle to water of from 40° to 60°, and hydrophilicity means a nature of a surface having a contact angle to water less than 40°. In the present specification, the contact angle is a value measured by a sessile drop test method disclosed in Examples.

In a case where the compound (A1), the compound (A2) or the compound (B) has a fluoroorganic group, by the contact angle to water of the water repellent region being particularly at least 85°, the water repellent region can have oil repellency. A surface having oil repellency can repel a lipophilic solvent (e.g. a hydrocarbon solvent), whereby even when a lipophilic solvent is used as a solvent for a functional material for formation of a functional film, it is possible to prevent the water repellent region from being coated with the functional material. Further, the non-water repellent region may have affinity to a lipophilic solvent. When the water repellency is represented by the contact angle to hexadecane, in a case where the compound (A1), the compound (A2) or the compound (B) contains a fluoroorganic group, the contact angle to hexadecane of the water repellent region is preferably at least 40°, particularly preferably at least 60°. The contact angle to hexadecane of the non-water repellent region is preferably at most 30°, particularly preferably at most 20°.

In a case where a liquid containing a functional material as described hereinafter is supplied, the higher the difference in the contact angle between the water repellent region and the non-water repellent region is, the more the liquid containing a functional material on both the water repellent region and the non-water repellent region tends to flow on the non-water repellent region, whereby on a pattern made of a film of the functional material obtained by drying the liquid containing the functional material, a pattern of a water repellent region and a non-water repellent region can accurately be realized.

Further, the smaller the absolute value of the contact angle of the non-water repellent region is, the better the liquid containing a functional material wettably spreads on the non-water repellent region, whereby the film thickness of a pattern made of a film of the functional material obtained by drying the liquid containing the functional material can be made uniform.

The film thickness of the water repellent cured film in the water repellent region can properly be selected depending on the purpose of use, and is preferably from 0.1 to 100 nm. If the film thickness is less than 0.1 nm, no sufficient water repellency may be obtained. Further, in a case where a patter made of a film of the functional material is formed and then the water repellent cured film is removed, the water repellent cured film is preferably thin from the viewpoint of removability. In such a case, the film thickness is more preferably from 0.1 to 50 nm, particularly preferably from 0.1 to 10 nm.

The non-water repellent region is usually a surface on which a functional thin film is to be formed, and is usually the surface of a substrate. In a case where the substrate is made of an inorganic material such as a metal or a metal compound such as a metal oxide, the substrate surface is usually hydrophilic. In a case where the substrate is made of an organic material such as a plastic, the substrate surface is usually hydrophobic. Accordingly, the non-water repellent region is the surface of such a substrate. Further, in a case of a substrate obtained by covering a base made of such a material with e.g. a thin film, the surface of the thin film or the like can be adjusted to have non-water repellency as different from that of the surface of the base. The base is a portion other than the thin film of the substrate having the thin film.

In the present invention, the material of the substrate is preferably glass; silicon (particularly a material constituting a silicon wafer); a metal or an alloy thereof, such as Pd, Pt, Ru, Ag, Au, Ti, In, Cu, Cr, Fe, Zn, Sn, Ta, W or Pb; a metal oxide such as PdO, SnO₂, In₂O₃, PbO or Sb₂O₃; a boride such as HfB₂, ZrB₂, LaB₆, CeB₆, YB₄ or GdB₄; a carbide such as TiC, ZrC, HfC, TaC, SiC or WC; a nitride such as TiN, ZrN or HfN; a material constituting a semiconductor such as Si or Ge; carbon ; a resin such as a polyimide, a polystyrene, a polyethylene terephthalate or a polytetrafluoroethylene. It is more preferably glass, a material constituting a silicon wafer, a metal oxide or a polyimide. It is preferred that such a material at least constitutes the surface of a substrate, and the entire substrate may be made of such a material.

Further, the substrate surface may be formed by surface treatment such as etching, polishing, surface oxidation or surface light irradiation. Such surface treatment is effective to make the substrate surface hydrophilic in many cases. Further, in a case where the substrate surface is stained with stains or impurities, the substrate is preferably cleaned. The above surface treatment is effective also for the cleaning in some cases. Further, the substrate may be a substrate having a thin film on its surface. A base made of the above material and having a thin film made of the above material or a material other than the above material formed on its surface may be used as the substrate. Such a thin film is preferably a thin film having surface characteristics of the non-water repellent region. Particularly preferred is a thin film made of a hydrophilic compound (such as a hydrophilic polymer) or a thin film formed by treatment with a hydrophilic treatment compound (such as a hydrolyzable silane for hydrophilic treatment).

Instead of using a substrate having a surface which is preliminarily made hydrophilic, a method may be employed wherein a coating film of a curable composition containing a hydrophilic compound is formed on the surface of a substrate and left at rest so that the hydrophilic compound migrates to the substrate side. A hydrophilic compound, which is a material having a high surface energy, tends to be oriented to the substrate side, and a compound having water repellency such as the above compound (A1) or the above compound (A2), which is a material having a low surface energy, tends to be oriented to the gas phase interface. Utilizing such a nature, a bilayer structure may be formed in which the hydrophilic compound is disposed on the substrate surface in the coating film of the curable composition. In a case where the hydrophilic compound is a hydrolyzable silane compound or the like, the hydrophilic compound is reacted on the substrate surface, whereby the substrate surface is made hydrophilic.

The shape of the substrate is not particularly limited, and preferred is a substrate having a flat surface, a curved surface or a flat surface having a partially curved surface as a surface on which a pattern is to be formed, and preferred is a substrate having a flat surface as a surface on which a pattern is to be formed. Particularly, a substrate in the form of a sheet or a film is preferred. In the case of the substrate in the form of a sheet or a film, it is preferred to form a pattern on one side of the substrate. Further, the surface area of a substrate is not particularly limited, and as far as conventional coating methods can be applied, the surface area of a substrate is not limited. The shape of a base is preferably the same as such a shape of a substrate.

On the treated substrate having a pattern of a water repellent region on a surface of a substrate of the present invention, the pattern shape is not particularly limited. The pattern is formed by a water repellent region and a non-water repellent region, and assuming that the non-water repellent region corresponds to the ground and the water repellent region corresponds to a figure (drawn on the ground), the figure comprises dots and lines. The area and the shape of the dots and the width and the length of the lines are not limited. In the present invention, a fine pattern can be formed. For example, in the case of a pattern constituted by lines, a pattern with a line width of at most 10 µm can be formed.

### <WASHING AND HYDROPHILIC TREATMENT OF SUBSTRATE>

As described above, it is preferred to preliminarily clean the surface of a substrate by washing for producing a treated substrate. Further, it is also preferred to subject the surface of a substrate to hydrophilic-treatment, and further, it is also preferred to use a substrate having a hydrophilic thin film formed on its surface. Such surface treatments can be carried out by common methods, and in some cases, it is difficult to distinguish such treatments. In the following, all such treatments are regarded as the hydrophilic treatment of a substrate and will be described below.

As a method for hydrophilic treatment of a substrate, conventional methods for hydrophilic treatment of the surface of plastics, metals, glass, ceramics, etc. can be employed. The method may, for example, be a method of wet-washing the surface of a substrate, a method of wet-oxidizing the surface of a substrate, a method of photo-washing the surface of a substrate, a method of photo-oxidizing the surface of a substrate, a method of coating the surface of a substrate with a hydrophilic compound or a combination thereof. A substrate made of a hydrophilic material can be used as it is, however, such a substrate usually tends to be stained. Therefore, it is preferred to preliminarily subject the substrate to hydrophilic treatment by wet-washing, photo-washing or a combination thereof before use. In a case where a substrate surface is made of a hydrophobic material and should be made hydrophilic, it is preferred to subject the substrate surface to hydrophilic treatment by wet-oxidizing, photo-oxidizing or applying a hydrophilic compound.

For the wet-washing of the substrate, water, an aqueous detergent or a non-aqueous detergent (an organic solvent, a fluorine type solvent, etc.) may be used. Particularly, a method is preferred wherein the substrate is washed with water or an aqueous detergent containing a surfactant, and then the substrate is dried, while contaminants, moisture, etc. on its surface are removed by using an organic solvent having a low boiling point such as isopropyl alcohol or ethyl alcohol. Further, depending on the type of the substrate, or the type or degree of stain, a step may be added, or a part of step may be omitted. It is preferred that in order to wet-wash a substrate stained with an organic matter, the substrate is preliminarily washed with a fluorine type solvent such as dichloropentafluoropropane (AK-225, manufactured by Asahi Glass Company, Limited, a mixture of CF₃CF₂CHCl₂ and CClF₂CF₂CHClF) to remove the stain, and then the substrate is immerse-washed with an aqueous detergent or an organic detergent. At the time of the immerse-washing, ultrasonic washing may be carried out in combination. In the case of glass, instead of the immerse-washing or with the immerse-washing, a method of polish washing with an abrasive containing cerium oxide fine particles, followed by rinsing the substrate with pure water and then air-drying may be employed.

In the wet-oxidizing the substrate, the surface is oxidized by using an aqueous solution of an oxidizing agent such as peroxide. The oxidizing agent is not particularly limited, and sulfuric acid, nitric acid, hydrogen peroxide, potassium persulfate, ammonium persulfate or potassium permanganate may, for example, be mentioned. The method of wet-oxidizing the substrate is not particularly limited so long as the substrate surface can be coated with the aqueous solution, and a spin coating method, a dip coating method, a spray coating method or a roll coating method may, for example, be employed.

As the method of photo-washing or photo-oxidizing the substrate, UV treatment, UV/O₃ treatment (treatment with ultraviolet light, ozone or a combination thereof), plasma treatment, corona discharging treatment or flame treatment may, for example, be mentioned, and the UV/O₃ treatment is preferred.

Further, only by the wet-washing, fine organic stains (for example, residues of the surfactant in a detergent or suspended matters in the clean room) are likely to remain. Whereas, the above photo-washing is free from the problem of the fine organic stains. Accordingly, a method is preferred wherein at first, relatively large stains are removed by the wet-washing, and then the substrate is washed by the photo-washing.

The hydrophilic compound which may be used in the hydrophilic treatment of the substrate surface may, for example, be a hydrophilic polymer such as a poly(vinyl alcohol), a poly(vinyl pyrrolidone) or a poly(ethylene glycol); or a polyhydric alcohol such as glycerol, pentaerythritol or sorbitol. The compound for hydrophilic treatment which reacts on the substrate surface and forms a hydrophilic residue on the surface may, for example, be a hydrolyzable silane compound having a hydrophilic group such as Si(OCH₃)₄, Si(OCH₂CH₃)₄, HSi(OCH₂CH₃)₃, NH₂CH₂CH₂CH₂Si(OCH₂CH₃)₃ or Si(NCO)₄, a compound having said compound partially or entirely hydrolyzed, or a hydrolytic condensate of said compound. In a case where H-Si(OCH₂HC₃)₃ is used, after it is reacted on the surface, washing with a sodium hydroxide aqueous solution at a level of 0.1 mol/L is required.

It is preferred that the hydrophilic compound or the compound for hydrophilic treatment is applied in the form of a solution dissolved in a solvent. The hydrophilic polymer and the polyhydric alcohol are preferably dissolved in water, and the silane compound is preferably dissolved in an alcohol solvent such as isopropyl alcohol. The concentration of such a compound in the solution is preferably from 0.01 to 10 mass%, more preferably from 0.1 to 1 mass%.

The method of coating the substrate with such a solution is not particularly limited, and a spin coating method, a dip coating method, a spray coating method, a roll coating method, a meniscus coating method or a screen printing method may, for example, be employed. After the coating, the solvent is removed to obtain a surface which is made hydrophilic.

In a case where the surface of the substrate is made of various different materials, as the hydrophilic treatment, it is preferred to employ a method of making the surface of the substrate be hydrophilic with the hydrophilic compound or the compound for hydrophilic treatment, whereby the same hydrophilic property can be imparted to the surface made of various materials.

### <PROCESS FOR PRODUCING TREATED SUBSTRATE>

A process for producing the treated substrate of the present invention is not particularly limited, however, as described above, the treated substrate is preferably produced by a lithography method. Now, the process for producing a treated substrate by the lithography method will be described. Each step (e.g. a step of forming a coating film) in this process is a method applicable to a process other than the lithography method, and the following description is not limited to the lithography method.

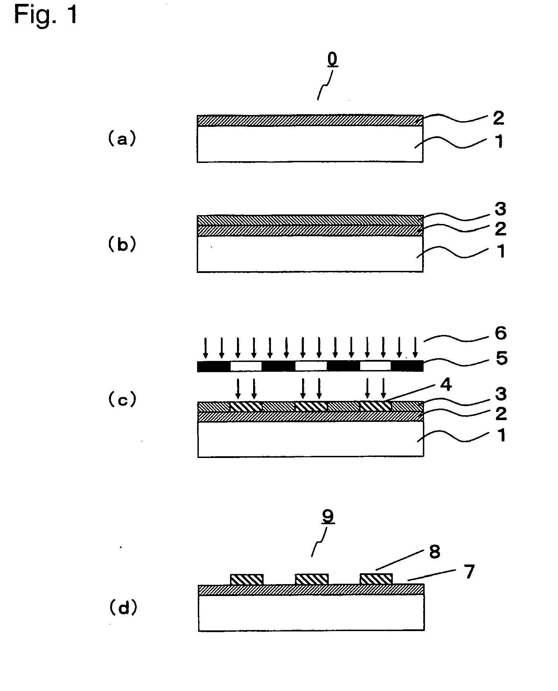

The production process by the lithography method comprises a step of forming a coating film containing a curable composition on a surface of a substrate (hereinafter referred to as a coating film-forming step), a step of irradiating a part of the surface of the coating film with light to cure the curable composition on the portion irradiated with light thereby to form a water repellent cured film (hereinafter referred to as a curing step) and a step of removing the uncured curable composition present on the surface of the substrate (hereinafter referred to as a developing step) in this order. One example of the production process comprising these steps will be specifically described with reference to Fig. 1.

Fig. 1 (a) illustrates one example of a substrate. This substrate (0) comprises a base (1) and a hydrophilic thin film (2) formed on one surface of the base. Fig. 1 (b) illustrates one having a coating film (3) of the above curable composition formed on the surface of the substrate by the coating film-forming step. Fig. 1 (c) illustrates the curing step. The coating film of the curable composition is irradiated with light (6) through a mask (5), and the light transmitted through a light-transmitting portion of the mask (5) cure the coating film of the curable composition. A portion of the coating film irradiated with light is cured to be a water repellent cured film (4), and a portion not irradiated with light is not substantially cured. Fig. 1 (d) illustrates a treated substrate (9) obtained by the developing step. The surface of the treated substrate (9) has a pattern formed by a water repellent region (8) made of the surface of the water repellent cured film and a non-water repellent region (7) of the substrate surface.

In the coating film-forming step, as described above, using a solution of the curable composition, the solution is applied to the substrate surface to form a coating film (wet film) of the solution, and then the solvent is removed to form a coating film of the curable composition. As the method of applying the solution of the curable composition to the substrate surface, a method such as spin coating, dip coating, wire bar coating, blade coating or roll coating may be employed. The application is carried out preferably at room temperature or under heating. Removal of the solvent is preferably removable by evaporation of the solvent (hereinafter sometimes referred to as drying), and is carried out preferably in the air, in a nitrogen stream or the like. The drying is preferably carried out at room temperature. In a case where the drying is carried out under heating, it is preferred to properly adjust the temperature and the time, depending on the heat resistance of the material of the substrate.

In the curing step, a part of the surface of the coating film is irradiated with light. Light used for irradiation is preferably light having a wavelength of at least 200 nm, more preferably light having a wavelength of at least 300 nm. Further, light having a wavelength of at most 380 nm is preferred, light having a wavelength of at most 365 nm is more preferred. When the wavelength of the light is at least 200 nm, decomposition of the substrate can be prevented in most cases. Further, a photocuring-accelerating compound (C) which initiates curing reaction by irradiation with light having a wavelength of at most 380 nm is easily available, and the light source is also not expensive. Irradiation time is properly changed, depending on the wavelength of light, the intensity of light, the type of the light source, the type of the composition, etc. In a case of an ultrahigh-pressure mercury lamp, irradiation time is from 5 to 120 seconds with from 2 to 100 mw/cm². In general, irradiation time with a high-pressure mercury lamp is shorter than that with an ultrahigh-pressure mercury lamp.

As the light source, a low-pressure mercury lamp, a high-pressure mercury lamp, an ultrahigh-pressure mercury lamp, a xenon lamp, a sodium lamp, a gas laser of e.g. nitrogen, a liquid laser of an organic dye solution or a solid laser of an inorganic single crystal having a rare earth element ion incorporated, may, for example, be mentioned. Further, as a light source other than a laser capable of providing a monochromatic light, a light having a desired wavelength, which is obtained by subjecting a broadband line spectrum or a continuous spectrum to an optical filter such as a bandpass filter or a cut-off filter, may be used. Since a large area can be irradiated with light at once, a high-pressure mercury lamp or an ultrahigh-pressure mercury lamp is preferred as the light source.

Light irradiation is preferably carried out through a photomask. By this method, the curing reaction can be carried out only at a desired region on the film surface, and a treated substrate on which a desired pattern of a water repellent region and a non-water repellent region is formed can be obtained.

The atmosphere for light irradiation can be optionally selected. In a case where a water repellent cured film having a thickness of at most 100 nm is formed by curing the curable composition, since cure inhibition due to oxygen may sometimes occur, light irradiation is preferably carried out under an inert gas atmosphere such as nitrogen. The inert gas may, for example, be a gas selected from nitrogen, argon, helium and carbon dioxide, and nitrogen gas is preferred, since it is inexpensive.

Light irradiation may be carried out from either side of the substrate, as long as light has a wavelength which can transmit through the substrate. Usually, it is preferred to apply light from the side of the film containing the composition.

If light or laser is applied though a photomask, a treated substrate on which a desired pattern of a water repellent region and a non-water repellent region is formed can be obtained. Further, it is possible to form a pattern such that the line width of the water repellent region and the non-water repellent region is at most 10 µm.

In the present invention, in a case where a flexible substrate such as a plastic substrate is used as the substrate, by irradiating the substrate with light by installing plural rolls and an exposure apparatus between the plural rolls so that Roll to Roll method can be carried out, a treated substrate can be obtained with a high throughput.

In the developing step, an uncured curable composition remained on the substrate surface is removed. By removing the uncured curable composition, the substrate surface is exposed. As a method for removing the uncured curable composition, in a case where the compound (A1), the compound (A2), the compound (B) or the like is a low molecular weight compound, it is preferred to remove the uncured curable composition by blowing nitrogen stream. In a case where such a compound is a high molecular weight compound, since the composition is not likely to evaporate, it is preferred to wash the surface on which the uncured curable composition remains with an organic solvent. The organic solvent to be used for washing is preferably a solvent which dissolves the respective components in the uncured curable composition The organic solvent may, for example, be an alcohol solvent such as methanol, ethanol or isopropanol, an ester solvent such as ethyl acetate or butyl acetate or a hydrocarbon solvent such as hexane.

### <MEMBER HAYING PATTERN MADE OF FILM OF FUNCTIONAL MATERIAL FORMED THEREON>

The present invention further provides a process for producing a member having a pattern made of a film of a functional material formed thereon (hereinafter sometimes referred to as a functional film-formed member). This process comprises a step of supplying a liquid containing a functional material to the surface of the above treated substrate of the present invention to coat the surface other than the water repellent region with the liquid (hereinafter referred to as a functional film-forming step 1) and a step of removing the solvent form the liquid to form a pattern made of a film of the functional material (hereinafter referred to as a functional film-forming step 2). Further, a step of removing the water repellent cured film (hereinafter referred to as a cured film-removing step) may be carried out after the functional film-forming step 2 to produce a member having the water repellent cured film removed.

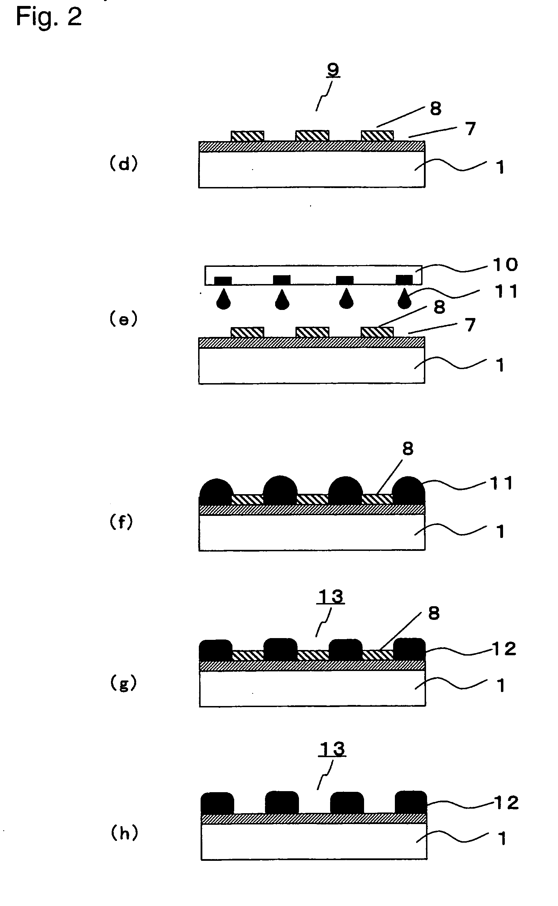

One example of the process for producing a functional film-formed member comprising such steps will be specifically described with reference to Fig. 2

Fig. 2(d) illustrates the same treated substrate as shown in Fig. 1 (d). The surface of the treated substrate (9) has a pattern formed by a water repellent region (8) comprising the surface of a water repellent cured film and a non-water repellent region (7) of the substrate surface. Fig. 2(e) illustrates the functional film-forming step 1. A liquid (11) containing a functional material is supplied to the surface of the treated substrate from a liquid supplying apparatus (10) to coat the surface other than the water repellent region (non-water repellent region (7)) with the liquid (11). The liquid supplying apparatus (10) may, for example, be an ink jet apparatus. Even when the liquid (11) is brought into contact with the surface of the water repellent region (8), the liquid is repelled by high water repellency (and high oil repellency) of the surface of the water repellent region, and the surface of the water repellent region (8) is not coated with the liquid (11). Fig. 2(f) illustrates the substrate after the functional film-forming step 1. The surface of the water repellent region (7) is filled with the liquid (11), and the liquid (11) is not present on the surface of the water repellent region (8). As shown in Fig. 2(f), it is considered that the surface of the water repellent region (8) is not covered with the liquid (11) even if the liquid (11) rises higher than the height of the water repellent cured film.

Fig. 2(g) illustrates a functional film-formed member (13) obtained after the functional film-forming step 2. The solvent is removed from the liquid (11) containing the functional material, and a pattern comprising a film (12) of the functional material and the other portion is formed. Fig. 2(h) illustrates a functional film-formed member (13) having a water repellent cured film at the water repellent region (8) removed, obtained from the functional film-formed member (13) shown in Fig. 2(g) by the cured film-removing step.

The functional material may, for example, be a metal particles-dispersed paste for forming metal wiring, a pigment material for forming a color filter, a ceramic material for forming an electronic device or an organic display, or an organic semiconductor material.

The liquid containing a functional material means a liquid or a liquid-form product wherein a functional material is dissolved or dispersed in a solvent such as water, an organic solvent or a mixture thereof. In a case where the water repellent region on the treated surface of the present invention has oil repellency as mentioned above, as the organic solvent, a low polar organic solvent may be used. The organic solvent is not particularly limited and may, for example, be an alcohol such as methanol, ethanol, propanol or butanol; a hydrocarbon such as n-pentane, n-hexane, n-heptane, n-octane, decane, dodecane, tetradecane, hexadecane, octadecane, cyclohexane, toluene, xylene, tetrahydronaphthalene or decahydronaphthalene; an ether compound such as ethylene glycol dimethyl ether, ethylene glycol diethyl ether, ethylene glycol methyl ethyl ether, diethylene glycol dimethyl ether, diethylene glycol diethyl ether, diethylene glycol methyl ethyl ether, tetrahydrofuran or dioxane; or a polar compound such as propylene carbonate, γ-butyrolactone, N-methyl-2-pyrrolidone, dimethylformamide, dimethylsulfoxide or cyclohexanone. Among them, from the viewpoint of solubility, dispersibility and stability, it is preferred to select an appropriate solvent. Such an organic solvent may be used alone or as a mixture of two or more of them.

The method of applying the liquid in the functional film-forming step 1 may, for example, be a coating method such as spin coating, dip coating, wire bar coating, blade coating or roll coating, or a printing method for a specific region such as screen printing or ink jet printing. Among them, with a view to selectively coating the non-water repellent region on the pattern comprising the water repellent region and the non-water repellent region, the screen printing or the ink jet printing is preferred.

The removal of the solvent in the functional film-forming step 2 is preferably carried out by removing the solvent by evaporation (sometimes referred to as drying), in the same manner as described above. The drying is preferably carried out in the air, in a nitrogen stream or the like. Further, the drying is preferably carried out at room temperature or under heating. In a case where the drying is carried out under heating, it is preferred to properly adjust the temperature and the time depending on the heat resistance of the material of the substrate.

For an electronic element or the like, a functional film-formed member from which the water repellent cured film is removed is useful. The water repellent cured film is removed, because in a case where the member is used as an electronic element, the water repellent cured film may influence the operation of the element. In the cured film-removing step, it is preferred to remove the water repellent cured film by washing the member with an alkaline solution. Otherwise, the member may be washed by immersing it in an alkaline solution. The alkaline solution may be an aqueous solution or a methanol solution of an alkali metal hydroxide (such as sodium hydroxide or potassium hydroxide) or an aqueous solution or a methanol solution of tetramethylammonium hydroxide. The concentration of the solution of the alkali metal hydroxide or tetramethylammonium hydroxide is preferably from 0.05 to 1.0 mol/L. The washing or immersion is carried out at a temperature of from 10 to 50°C for from 0.5 minute to 1.0 hour.

Further, the water repellent cured film may be removed by subjecting the member to UV/O₃ treatment. For example, it is preferred that PL7-200 (manufactured by CENT ENGINEERING CO., LTD.) is used as a UV/O₃ generator, and the member is irradiated for from 1 to 3 minutes.

In a case where the water repellent cured film is removed, from the viewpoint of removability, the water repellent cured film is preferably thin. As described above, the film thickness is preferably from 0.1 to 50 nm, particularly preferably from 0.1 to 10 nm.

### EXAMPLES

Now, the present invention will be described in further detail with reference to Examples (Examples 1 to 4 and 6 (Examples of the present invention) and Example 5 (Comparative Example)). However, it should be understood that the present invention is by no means restricted thereto.

### (PREPARATION OF SOLUTION (1))

Isopropyl alcohol (2.5 g) was added in a sample vessel. A 10 mass% isopropyl alcohol solution (0.1 g) of a methylhydrogen silicone oil having trimethylsilyl groups at both terminals of the molecule (KF-99, manufactured by Shin-Etsu Chemical Co., Ltd., a compound of the above formula (a1) wherein m is a number of at least 1, n=0, k=0 and W¹=CH₃, molecular weight: 1,400, corresponding to the compound (A2)) was added. Further, a 1 mass% isopropyl alcohol solution (0.2 g) of dipentaerythritol hexaacrylate (corresponding to the compound (B)) and a 1 mass% isopropyl alcohol solution (0.06 g) of IRGACURE 907 (manufactured by CIBA-GEIGY, Limited) as a photoradical polymerization initiator were added. The sample vessel was shaken a few times to mix the solution thereby to obtain a solution of a curable composition. Hereinafter this solution will be referred to as a solution (1).

### (PREPARATION·OF SOLUTION (2))

Isopropyl alcohol (2.5 g) was added to a sample vessel. A 10 mass% isopropyl alcohol solution (0.1 g) of a methylhydrogen silicone oil having trimethylsilyl groups at both terminals of the molecule (KF-99, manufactured by Shin-Etsu Chemical Co., Ltd., corresponding to the compound (A2)) was added. Further, a 1 mass% isopropyl alcohol solution (0.2 g) of (CH₂=CH)(CH₃)₂SiO-[(CH₃)₂SiO]ₙ-Si(CH₃)₂(CH=CH₂) (DMS-V21, manufactured by Gelest, Inc, molecular weight: 6,000, corresponding to the compound (B)) and a 1 mass% tetrahydrofuran solution (0.07 g) of bis(acetylacetonate)platinum(II) (manufactured by Sigma-Aldrich Co.) were added. The sample vessel was shaken a few times to mix the solution thereby to obtain a solution of a curable composition. Hereinafter this solution will be referred to as a solution (2).

### (PREPARATION OF SOLUTION (3))

Isopropyl alcohol (2.5 g) was added in a sample vessel. A 10 mass% isopropyl alcohol solution (0.1 g) of a methylhydrogen silicone oil having trimethylsilyl groups at both terminals of the molecule (KF-99, manufactured by Shin-Etsu Chemical Co., Ltd., corresponding to the compound (A2)) was added. Further, a 1 mass% isopropyl alcohol solution (0.2 g) of pentaerythritol polyglycidyl ether (EX-411, manufactured by Nagase ChemteX Corporation, corresponding to the compound (B)), a 1 mass% isopropyl alcohol solution (0.06 g) of IRGACURE 250 (manufactured by CIBA-GEIGY, Limited) as a cationic photopolymerization initiator and a 1 mass% isopropyl alcohol solution (0.03 g) of DETX (manufactured by Nippon Kayaku Co., Ltd.) as a sensitizer were added. The sample vessel was shaken a few times to mix the solution thereby to obtain a solution of a curable composition. Hereinafter this solution will be referred to as a solution (3).

### (PREPARATION OF SOLUTION (4))

HSi(OC₂H₅)₃ (3.2 g), CH₂=C(CH₃)COO(CH₂)₃Si(OCH₃)₃ (manufactured by TOKYO CHEMICAL INDUSTRY CO., LTD., 0.16 g), CF₃(CF₂)₅CH₂CH₂Si(OCH₃)₃ (TSL8257, manufactured by GE Toshiba Silicone, 1 g) and H(CH₃)₂SiOSi(CH₃)₂H (LS-7040, manufactured by Shin-Etsu Chemical Co., Ltd., 4.3 g) were put in a 100 ml three-necked flask equipped with a stirrer. Then, hexane (28 g) and isopropyl alcohol (12 g) were put.

1.8 g of a 1.28% aqueous hydrochloric acid solution was dropwise added with stirring. After completion of the dropwise addition, stirring was carried out further for 1 hour. Then, the solvent was removed to obtain a liquid product (corresponding to the compound (A1)). The obtained liquid product was dissolved in isopropyl alcohol to prepare a 10 mass% isopropyl alcohol solution of the liquid product.

A solution of a curable composition was obtained in the same manner as in preparation of the solution (1) except that the above 10 mass% isopropyl alcohol solution of the liquid product was used instead of the 10 mass% isopropyl alcohol solution of the methylhydrogen silicone oil. Hereinafter this solution will be referred to as a solution (4).

### (PREPARATION OF SOLUTION (5))

A solution of a curable composition was obtained in the same manner as in preparation of the solution (1) except that a dimethylsilicone oil (KF-96-50cs, manufactured by Shin-Etsu Chemical Co., Ltd., a compound of the above formula (a1) wherein m=0, n=0, k is a number of at least 1, R¹=CH₃ and W¹=CH₃) was used instead of the methylhydrogen silicone oil having trimethylsilyl group at both terminals of the molecule. Hereinafter this solution will be referred to as a solution (5).

### EXAMPLE 1: Preparation of treated substrate 1

### (Substrate wash)

A 5 cm square silicon wafer was washed with ethanol and then subjected to UV/O₃ washing.

### (Coating with solution)

The silicon wafer was coated with the prepared solution (1) by spin coating (3,000 rpm, 20 seconds).

### (Light irradiation)

A surface of the obtained thin film was irradiated with ultraviolet light (wavelength: 300 to 450 nm) from an ultrahigh-pressure mercury lamp at 100 mw/cm² for 30 seconds through a photomask having a pore pattern (2.5 cm x 5 cm).

### (Substrate wash)

The substrate was rinsed with isopropyl alcohol, then rinsed with ethanol and then dried in a nitrogen stream, whereby a treated substrate 1 was obtained.

### EXAMPLE 2: Preparation of treated substrate 2

A treated substrate 2 was obtained in the same manner as in preparation of the treated substrate in Example 1 except that the solution (1) was changed to the solution (2), and the light irradiation conditions were changed at 100 mw/cm² for 60 seconds.

### EXAMPLE 3: Preparation of treated substrate 3

A treated substrate 3 was obtained in the same manner as in preparation of the treated substrate in Example 1 except that the solution (1) was changed to the solution (3), and the light irradiation conditions were changed at 100 mw/cm² for 60 seconds.

### EXAMPLE 4: Preparation of treated substrate 4

A treated substrate 4 was obtained in the same manner as in preparation of the treated substrate in Example 1 except that the solution (1) was changed to the solution (4).

### EXAMPLE 5: Preparation of treated substrate 5

A treated substrate 5 was obtained in the same manner as in preparation of the treated substrate in Example 1 except that the solution (1) was changed to the solution (5).

The treated substrates obtained in Examples 1 to 5 were subjected to the following evaluation. (Film thickness measurement)

The film thickness of the water repellent thin film was measured by an atomic force microscope (AFM). It was 8 nm in the treated substrate in Example 1.

### (Measurement of contact angle)

The contact angle to water of the surface of the treated substrate was measured. The contact angle to water was measured by putting water droplets on three different spots on a surface of the substrate to be measured, and each droplet was measured in accordance with JIS R3257 "Testing method of wettability of glass substrate" by the sessile drop test method. The droplet was 2 µL/droplet, and the measurement was carried out at 20°C. The contact angle is represented by an average value of three droplets (n=3). The contact angle to hexadecane was also measured in the same manner. The results are shown in Table 1. In Examples 1 to 5, formation of a treated substrate having a hydrophilic region and a water repellent region was confirmed.

### (Removal of water repellent film)

The treated substrate obtained by the above steps was immersed in a 0.1 mol/L sodium hydroxide aqueous solution for 1 minute, rinsed with distilled water and then dried at room temperature in a nitrogen stream. Then, the contact angle to water of the surface of the substrate was measured. The results are shown in Table 1. In Examples 1 to 4, removal of the water repellent film was confirmed, but in Example 5, the water repellent film could not be removed.

**TABLE 1**

| Example | Contact angle (degree) of treated surface | | | | Contact angle (degree) after removal of water repellent film | |
|---|---|---|---|---|---|---|
| | Water | | Hexadecane | | Water | |
| | Irradiated part | Shaded part | Irradiated part | Shaded part | Irradiated part | Shaded part |
| 1 | 100 | 14 | 30 | 10 | 9 | 5 |
| 2 | 103 | 12 | 31 | 11 | 10 | 5 |
| 3 | 101 | 10 | 28 | 11 | 8 | 5 |
| 4 | 107 | 9 | 46 | 11 | 7 | 5 |
| 5 | 102 | 12 | | | | |

### EXAMPLE 6: Preparation of treated substrate having water repellent/hydrophilic pattern formed thereon

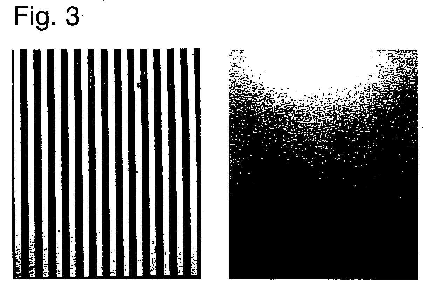

A treated substrate having a pattern of a hydrophilic region and a water repellent region was obtained in the same manner as in Example 1 except that a photomask of 10 µmL/S was used at the time of light irradiation. The substrate surface was observed by SEM. The photograph is shown in Fig. 3 (left). Formation of a light-dark pattern with a 10 µm width was confirmed.

Further, the treated substrate was immersed in a 0.1 mol/L sodium hydroxide aqueous solution (25°C) for 1 minute, rinsed with distilled water and dried in a nitrogen stream at room temperature. The substrate surface was observed by SEM. The photograph is shown in Fig. 3 (right). It was confirmed that the water repellent film was removed, and the light-dark pattern disappeared.

### INDUSTRIAL APPLICABILITY

According to the present invention, a fine water repellent/non-water repellent pattern comprising a water repellent region and a non-water repellent region can be formed without employing a large facility, a vacuum apparatus or a high energy light source. In a case where a functional material-containing ink is sprayed on the pattern by using an ink-jet, since only the non-water repellent region is coated with the functional material-containing ink, and the water repellent region is not coated with the ink, patterning can be carried out on the substrate with the functional material-containing ink. Further, the present invention can also be applied for forming electronic device circuits. Accordingly, the functional film-formed member of the present invention can be suitably applied for e.g. production of wiring pattern in a color filter for an ink jet liquid crystal, an organic EL display, a semiconductor apparatus or an electronic circuit by an ink jet method.

Further, it is possible to incorporate the functional material-containing ink in the non-water repellent region of the treated substrate having a water repellent/non-water repellent pattern thereby to transfer the functional material to another substrate.

Further, the treated substrate having a water repellent/non-water repellent pattern on the surface of a substrate of the present invention may be applicable in the medical fields. For example, a mask having a pattern so that the blood vessel portion of capillaries corresponds to the non-water repellent region (particularly hydrophilic region) is prepared, and the pattern of the capillaries is transferred to a substrate. Blood vessel epithelial cells are spread thereon, and the cells were multiplied only in the non-water repellent region to reproduce the pattern of the capillaries.

Further, with the treated substrate having a water repellent/non-water repellent pattern on the surface of a substrate of the present invention, utilizing reactivity of e.g. hydroxyl groups present on the surface of the non-water repellent region (particularly hydrophilic region), a compound having other property is reacted on the surface of the non-water repellent region to form a substrate having water repellency and said other property.

The entire disclosure of Japanese Patent Application No. 2007-051623 filed on March 1, 2007 including specification, claims, drawings and summary is incorporated herein by reference in its entirety.

## Claims

1. A treated substrate having a pattern of a water repellent region on a surface of a substrate, **characterized in that** the water repellent region is made of a water repellent cured film obtained by curing a curable composition containing the following compound (A1), or the following compound (A2) and the following compound (B), and further optionally containing a photocuring-accelerating compound (C):
compound (A1): an organopolysiloxane having hydrogen atoms bonded to silicon atoms and a photocurable group;
compound (A2): an organopolysiloxane having hydrogen atoms bonded to silicon atoms and having no photocurable group; and
compound (B): a compound having a photocurable group.

2. The treated substrate according to Claim 1, wherein the photocurable group is an acryloyl group or a methacryloyl group, and the photocuring-accelerating compound (C) is a radical generator which generates radicals by light.

3. The treated substrate according to Claim 1, wherein the photocurable group is a 1,2-epoxy group, and the photocuring-accelerating compound (C) is a cation generator which generates cations by light.

4. The treated substrate according to Claim 1, wherein the photocurable group is a vinyl group, and the photocuring-accelerating compound (C) is a platinum catalyst.

5. The treated substrate according to any one of Claims 1 to 4, wherein the contact angle of the substrate surface other than the water repellent region to water is at most 50°, and the contact angle of the water repellent region to water is at least 70°.

6. The treated substrate according to any one of Claims 1 to 5, wherein the film thickness of the water repellent cured film is from 0.1 to 100 nm.

7. The treated substrate according to any one of Claims 1 to 6, wherein in the above compound (A1) or the above compound (A2), the average number of hydrogen atoms bonded to silicon atoms is from 0.1 to 1.0 atom per one silicon atom.

8. A process for producing a treated substrate having a pattern of a water repellent region on its surface, **characterized in that** a treated substrate having a pattern of a water repellent region made of a water repellent cured film on its surface is produced by a process comprising a step of forming a coating film containing the following curable composition on a surface of a substrate, a step of irradiating a part of the surface of the coating film with light to cure the curable composition at the portion irradiated with light thereby to form a water repellent cured film, and a step of removing an uncured curable composition present on the surface of the substrate, in this order:
curable composition: a curable composition containing the following compound (A1), or the following compound (A2) and the following compound (B), and further optionally containing a photocuring-accelerating compound (C):
compound (A1): an organopolysiloxane having hydrogen atoms bonded to silicon atoms and a photocurable group;
compound (A2): an organopolysiloxane having hydrogen atoms bonded to silicon atoms and having no photocurable group; and
compound (B): a compound having a photocurable group.

9. The production process according to Claim 8, wherein light having a wavelength of at least 200 nm is applied.

10. A process for producing a functional film-formed member, **characterized in that** a pattern of a functional film is formed on a surface of a substrate by a process comprising a step of supplying a liquid containing a functional material and a solvent to a surface of the treated substrate as defined in any one of Claims 1 to 7 to coat the region other than the water repellent region on the surface of the treated substrate with the liquid, and a step of removing the solvent from the liquid to form a pattern made of a film of the functional material.

11. A process for producing a functional film-formed member, **characterized in that** a pattern of a functional film is formed on a surface of a substrate by a process comprising a step of supplying a liquid containing a functional material and a solvent to a surface of the treated substrate as defined in any one of Claims 1 to 7 to coat the region other than the water repellent region on the surface of the treated substrate with the liquid, a step of removing the solvent from the liquid to form a pattern made of a film of the functional material, and a step of removing the water repellent cured film.

12. The process for producing a functional film-formed member according to Claim 11, wherein the water repellent cured film is removed by washing with an alkaline solution.
